# EUROPÄISCHE PATENTSCHRIFT

(11) **EP 2 736 311 B1**
(45) Veröffentlichungstag und Bekanntmachung des Hinweises auf die Patenterteilung: **16.08.2017**
(21) Anmeldenummer: 12194362.5
(22) Anmeldetag: 27.11.2012
(51) Int. Cl.: H05K 7/14, H05K 7/20

(54) **Automatisierungsgerät mit Kühlkörper**
Automation device with cooling element
Appareil d'automatisation avec corps de refroidissement

(43) Veröffentlichungstag der Anmeldung: 28.05.2014
(73) Patentinhaber: Siemens Aktiengesellschaft, 80333 München (DE)
(72) Erfinder: Bäuml, Mathias, 92421 Schwandorf (DE); Michl, Julia, 93133 Burglengenfeld (DE); Schmelz, Jürgen, 90610 Winkelhaid (DE)

(56) Entgegenhaltungen:
- EP-A1- 0 618 758
- EP-A1- 1 793 289
- EP-A2- 0 845 930
- EP-A2- 2 073 616
- DE-A1- 10 316 967
- US-B1- 6 324 057

## Beschreibung

Die Erfindung betrifft ein Automatisierungsgerät ausgestaltet für den Einsatz in einem Automatisierungsumfeld zur Automatisierung eines industriellen Prozesses, aufweisend ein Grundgehäuse, eine Fronthaube, einen Hauptkühlkörper zum Abführen von Wärme eines Mikroprozessors, wobei die Fronthaube auf das Grundgehäuse aufsteckbar ist und zu einem geschlossenen Gehäuse zusammenfügbar ist, welches den Hauptkühlkörper umgibt.

Die Patentschrift US 6,324,057 B1 zeigt eine speicherprogrammierbare Steuerung mit einer schwimmend gelagerten Aufhängung für Leiterplatten.

Die EP 0 845 930 B1 zeigt ein Automatisierungsgerät mit einem Gehäuse, bei welchen ein Kabelanschlussraum optimiert wurde, um das Gehäuse kompakter zu gestalten.

Die europäische Offenlegungsschrift EP 2 073 616 A2 offenbart eine Geräteeinheit für eine CNC-Maschine, bei welcher eine Entwärmung der Geräteeinheit mittels zweier Radiallüfter realisiert ist.

Aufgrund einer Miniaturisierung von Elektronikkomponenten, wird zunehmend eine höhere Packungsdichte/Funktionsdichte an elektronischen Komponenten/Bauteilen auf einer Flachbaugruppe, wie beispielsweise einer bestückten Leiterplatte, realisiert. Dies führt zu einer Erhöhung der Verlustleistung, insbesondere bei Mikroprozessoren, da die Leistungsfähigkeit von Mikroprozessoren zunehmend steigt und damit auch eine Verlustwärme steigt. Der Einsatz von beispielsweise modernen Mikroprozessoren, wie sie für die Personal Computer Welt eingesetzt werden, in einem Automatisierungsgerät führt zu einem enormen Anstieg der Verlustleistung in dem Automatisierungsgerät.

Bei einem Automatisierungsgerät möchte man zum Abführen der Wärme aufgrund der Verlustleistung nicht unbedingt aktive Kühlkomponenten, wie z.B. einen Radiallüfter, einsetzen, weil diese wartungs- und störanfällig sind. Um aber dennoch die Verlustwärme effektiv abführen zu können, werden zur Wärmeabfuhr passive Entwärmungselemente, nämlich Kühlkörper, mit einer im Vergleich zu den Kühlkörpern in der Personal Computer Technologie wesentlich größeren Dimensionierung und einer wesentlich größeren Masse. Bei dem im Sinne der Erfindung vorgestellten Automatisierungsgerät kann demnach ein Kühlkörper eine Masse von ca. 1 kg erreichen.

Bei einem derart großen Kühlkörper ist es Aufgabe der Erfindung den Kühlkörper in dem Automatisierungsgerät derart zu integrieren, dass das Automatisierungsgerät die für die Industrie-Automatisierungstechnik bekannten Schwing- und Schockbeanspruchungen stand hält.

Die Aufgabe wird durch ein Automatisierungsgerät mit den Merkmalen des Anspruchs 1 gelöst.

Der Hauptkühlkörper ist an einer Unterseite des Grundgehäuses mittels eines Festlagers mit dem Grundgehäuse starr verbunden, die Fronthaube weist auf einer Innenseite ein hervorstehendes Halteelement auf, auf einer Oberseite des Hauptkühlkörpers ist eine Ausnehmung angeordnet in die das Halteelement bei geschlossenem Gehäuse eindringt, wobei zwischen dem hervorstehenden Halteelement und der Ausnehmung ein elastisches Formelement angeordnet ist, wobei das elastische Formelement ausgestaltet ist Schwingungskräfte des Hauptkühlkörpers in drei Raumachsen abzufangen.

Der Hauptkühlkörper kann auf einer Seite, hier auf der Unterseite des Grundgehäuses ausreichend massiv mit einem oder mehreren Festlagern befestigt werden. Aber auf der gegenüberliegenden Seite des Hauptkühlkörpers, in diesem Fall, die Seite, die zur Fronthaube gerichtet ist, dagegen eine massive starre Befestigung nicht möglich bzw. technisch nicht sinnvoll, da dies zu Verspannungen im gesamten Gehäuse führen würde. Zwei gegenüberliegende Festlager würden zu einem überbestimmten System führen und eine geometrische bzw. fertigungsgerechte Ausgestaltung wäre behindert.

Würde ein Hauptkühlkörper einzig und allein mit dem Festlager auf der Unterseite des Grundgehäuses befestigt sein, so kommt es bei Schwing- und Schockbeanspruchungen zu einer deutlichen, nicht zulässigen Überhöhung einer Amplitude der Bewegungsrichtungen des Hauptkühlkörpers. Dies könnte zu einem Versagen des Gerätes infolge von z.B. Gehäusebruch oder Beschädigung der elektronischen Bauteile oder ein Ablösen einer Kühlfläche von dem Mikroprozessor führen.

Durch die Ausgestaltung von hervorstehenden Halteelementen in der Fronthaube, wobei die Halteelemente zusätzlich ein elastisches Formelement tragen und das Halteelement mit dem Formelement in den Ausnehmungen des Hauptkühlkörpers eingesteckt ist, werden die Schwingungskräfte des Hauptkühlkörpers in den drei Raumachsen abgefangen.

Das elastische Formelement ist dabei so ausgeführt, dass die Toleranzen ausgeglichen und damit die Schwingungskräfte in allen drei Raumachsen optimal abgefangen werden. Hierzu ist es vorteilhaft, wenn das Grundgehäuse an seiner äußeren Unterseite so ausgestaltet ist, dass es auf einer Profilschiene befestigbar ist und die Fronthaube mit ihrem Halteelement wiederum so ausgestaltet ist, dass die Schwingungskräfte des Hauptkühlkörpers auf die Fronthaube übertragen werden und die Fronthaube die Schwingungskräfte des Hauptkühlkörpers auf das Grundgehäuse überträgt und das Grundgehäuse die Schwingungskräfte des Hauptkühlkörpers auf die Profilschiene überträgt.

Vorzugsweise ist das Halteelement als ein Befestigungsdom mit einer umlaufenden Nut und das elastische Formelement als ein O-Ring ausgestaltet, welcher in der Nut liegt. In der Fronthaube könnte beispielsweise ein stabiler Kunststoffdom ausgeprägt sein, auf welchem eine Nut für einen O-Ring eingeprägt ist. Dieser O-Ring stellt die Abstützung in allen drei Raumachsen sicher. Nach einer Montage der Fronthaube auf das Grundgehäuse findet sich dieser Dom mit dem O-Ring in einer kegelförmigen Aussparung im Hauptkühlkörper wieder, wobei eine Anlage des O-Ringes am Hauptkühlkörper in allen drei Raumachsen immer sichergestellt ist.

Vorteilhafterweise sind die Ausnehmungen im Hauptkühlkörper dazu kegelförmig ausgestaltet.

In einer weiteren optimierten Ausgestaltung des Automatisierungsgerätes weist dieses eine erste Leiterplatte, eine zweite Leiterplatte und einen Nebenkühlkörper auf, wobei die erste Leiterplatte zwischen der Unterseite des Hauptkühlkörpers und der Unterseite des Grundgehäuses angeordnet ist, wobei die erste Leiterplatte einen Durchbruch für das Festlager zur Verbindung des Grundgehäuses mit dem Hauptkühlkörper aufweist, die zweite Leiterplatte ist dabei senkrecht auf der ersten Leiterplatte angeordnet und trägt den Mikroprozessor auf der einen Seite der zweiten Leiterplatte und den Nebenkühlkörper auf der anderen Seite der zweiten Leiterplatte, dabei liegt eine Seitenfläche des Hauptkühlkörpers auf dem Mikroprozessor auf so dass der Nebenkühlkörper und der Hauptkühlkörper ein den Mikroprozessor umgebendes Kühlpaket bilden.

Damit eine Auflagefläche für den Mikroprozessor an dem Hauptkühlkörper möglichst gut an den Mikroprozessor anliegt, sind die Ausnehmungen im Hauptkühlkörper im Bereich der Kante des Hauptkühlkörpers, welche zum Nebenkühlkörper gerichtet ist, angeordnet.

Die Zeichnung zeigt ein Ausführungsbeispiel, wobei
- FIG 1: ein Automatisierungsgerät in dreidimensionaler Ansicht,
- FIG 2: das geöffnete Automatisierungsgerät in dreidimensionaler Ansicht,
- FIG 3: das Automatisierungsgerät ohne den Hauptkühlkörper in dreidimensionaler Ansicht,
- FIG 4: den Hauptkühlkörper in dreidimensionaler Ansicht,
- FIG 5: die Fronthaube,
- FIG 6: die Fronthaube mit Blickrichtung auf die Innenseite und
- FIG 7: einen Schnitt durch die Fronthaube, das Halteelement und den Hauptkühlkörper an der Stelle der Ausnehmung
zeigt.

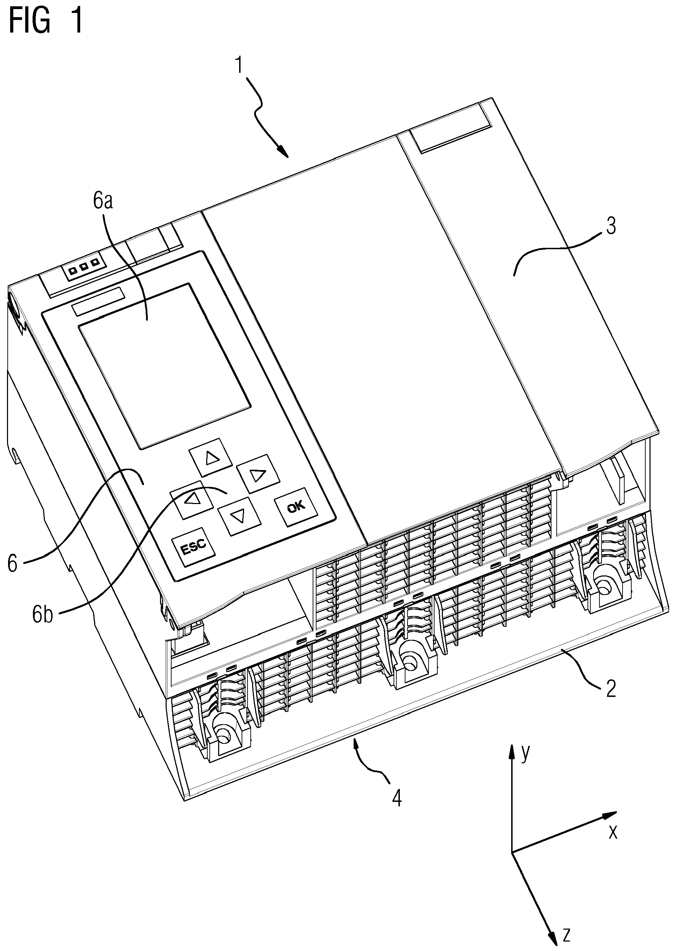

Gemäß FIG 1 ist ein Automatisierungsgerät 1 ausgestaltet für den Einsatz in einem Automatisierungsumfeld zur Automatisierung eines industriellen Prozesses abgebildet. Da Automatisierungsgeräte rauen Umgebungsbedingungen, wie Feuchtigkeit, Temperaturunterschiede, Vibrations- und Schockbelastungen unterliegen, müssen diese Automatisierungsgeräte besonders robust ausgeführt sein. Das gezeigte Automatisierungsgerät 1 weist ein Grundgehäuse 2 und eine Fronthaube 3 auf, wobei zusätzlich eine Frontklappe 6 mit einem integrierten Display 6a und einem integrierten Bedienfeld 6b dargestellt ist.

Rechts von dem Automatisierungsgerät 1 sind drei Raumachsen x,y,z dargestellt. Bei einer Schockbeanspruchung, Rüttelbeanspruchung oder Vibrationsbeanspruchung kann sich das Automatisierungsgerät 1 und insbesondere das Innenleben des Automatisierungsgerätes 1 in Richtung der drei Raumachsen x,y,z bewegen.

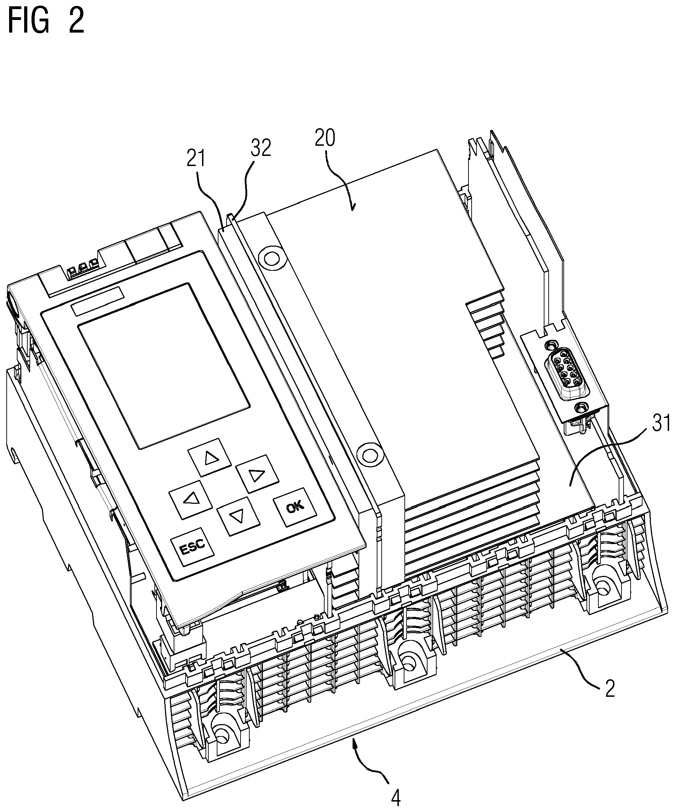

Die FIG 2 zeigt das aus FIG 1 bekannte Automatisierungsgerät 1 in einem geöffneten Zustand, wobei die Fronthaube 3 entfernt ist. Deutlich zu sehen ist nun der Hauptkühlkörper 20, welcher auf einer ersten Leiterplatte 31 angeordnet ist. Die erste Leiterplatte 31 wiederum liegt auf einer Unterseite 4 des Grundgehäuses 2 auf. Eine zweite Leiterplatte 32 steht senkrecht auf der ersten Leiterplatte 31 und ist zwischen dem Hauptkühlkörper 20 und einem Nebenkühlkörper 21 angeordnet. Der Hauptkühlkörper 20 und der Nebenkühlkörper 21 bilden ein Kühlkörperpaket. In dieser Darstellung mit der FIG 2 ist besonders deutlich der Größenvergleich von einem normalen (Nebenkühlkörper) zu einem besonders groß ausgestalteten Kühlkörper (Hauptkühlkörper) zu sehen. Da die modernen Mikroprozessoren zunehmend mehr Verlustwärme erzeugen, ist eine größere bauliche Anordnung eines Hauptkühlkörpers, wobei seine Masse bereits im Bereich von einigen Kilogramm liegen kann, nötig.

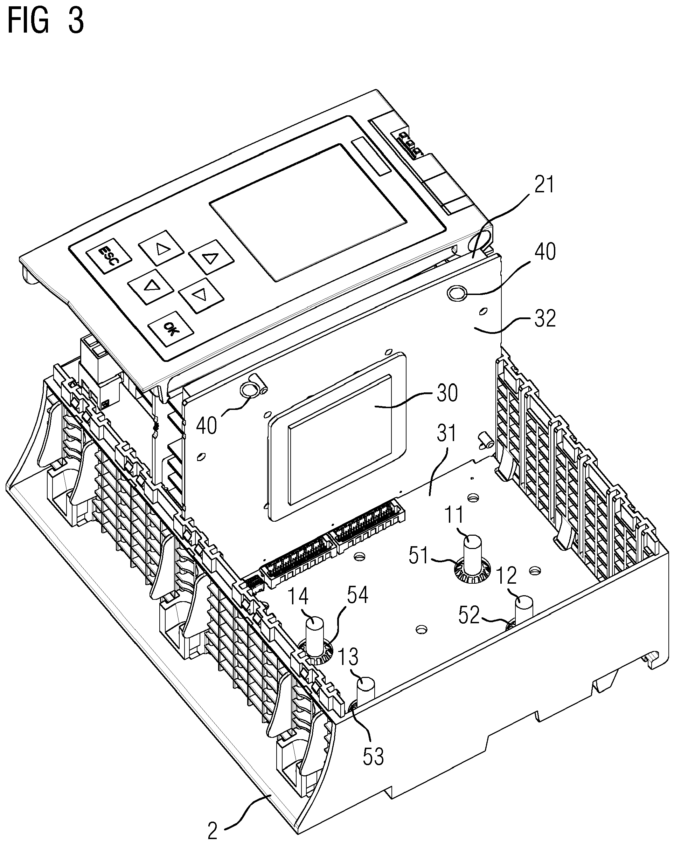

FIG 3 zeigt das Automatisierungsgerät 1 mit dem entfernten Hauptkühlkörper 20. Dabei zeigt die zweite Leiterplatte 32, dass sie den Mikroprozessor 30 trägt. Die erste Leiterplatte 31 weist einen ersten Durchbruch 51, einen zweiten Durchbruch 52, einen dritten Durchbruch 53 und einen vierten Durchbruch 54 auf. Durch welche jeweils ein Schraubenbolzen hindurchragen, und die Verschraubungen des Hauptkühlkörpers mit den Schraubenbolzen somit ein erstes Festlager 11, ein zweites Festlager 12, ein drittes Festlager 13 und ein viertes Festlager 14 bilden.

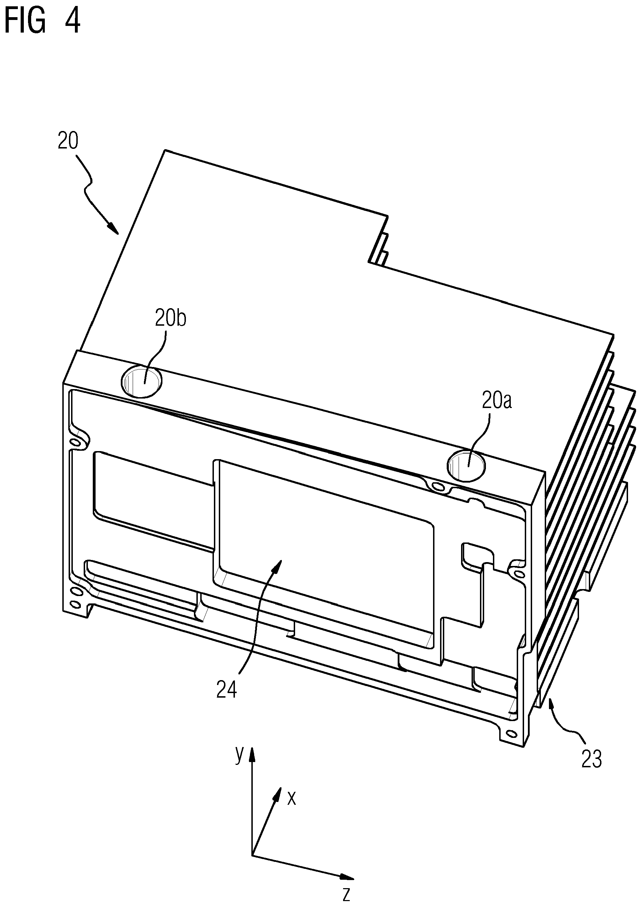

Gemäß FIG 4 ist der Hauptkühlkörper 20 in einer Einzeldarstellung abgebildet. Der Hauptkühlkörper 20 weist im Bereich der Kante, welche zum Nebenkühlkörper 21 (siehe FIG 2) gerichtet ist, eine erste Ausnehmung 20a und eine zweite Ausnehmung 20b auf. Mit einer Unterseite 23 steht der Hauptkühlkörper auf der ersten Leiterplatte 31 auf.

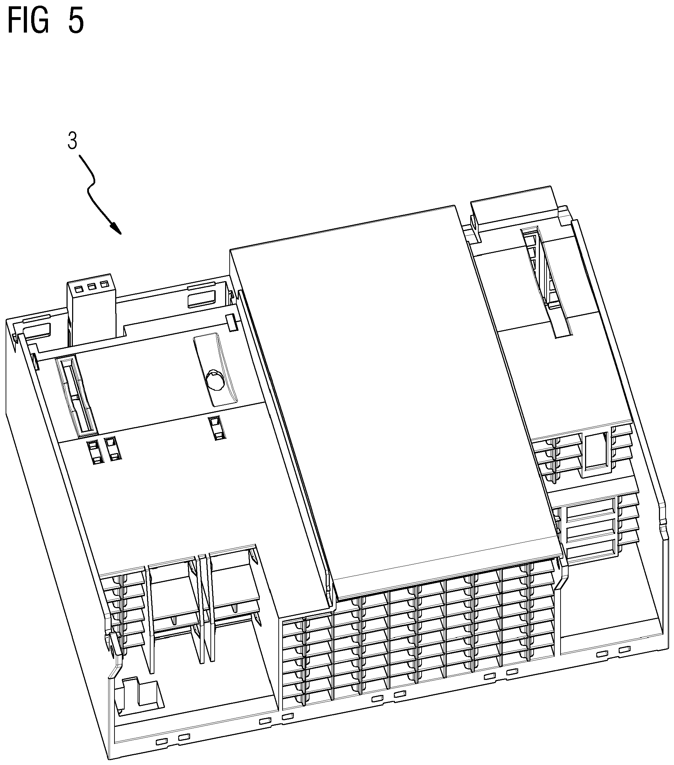

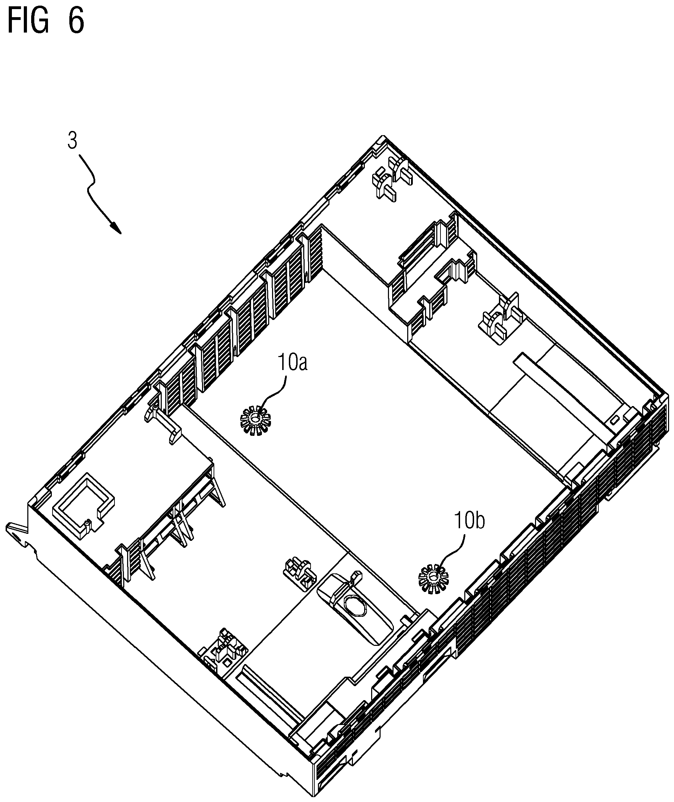

Mit der FIG 5 und 6 ist die Fronthaube 3 dargestellt, wobei die FIG 5 die Fronthaube 3 in einer Draufsicht auf die Außenseite und die FIG 6 die Fronthaube 3 in einer Draufsicht auf die Innenseite zeigt. Dabei wird insbesondere mit FIG 6 das erste Halteelement 10a und das zweite Halteelement 10b gezeigt. Bei einem Aufsetzen der Fronthaube 3 auf das Grundgehäuse 2 greift das erste Halteelement 10a in die erste Ausnehmung 20a des Hauptkühlkörpers 20 und das zweite Halteelement 10b greift in die zweite Ausnehmung 20b des Hauptkühlkörpers 20. Demnach sind in der Fronthaube 3 jeweils ein erster stabiler Kunststoffdom und ein zweiter stabiler Kunststoffdom ausgeprägt, auf welchen zusätzlich eine Nut 41 für einen O-Ring eingebracht ist.

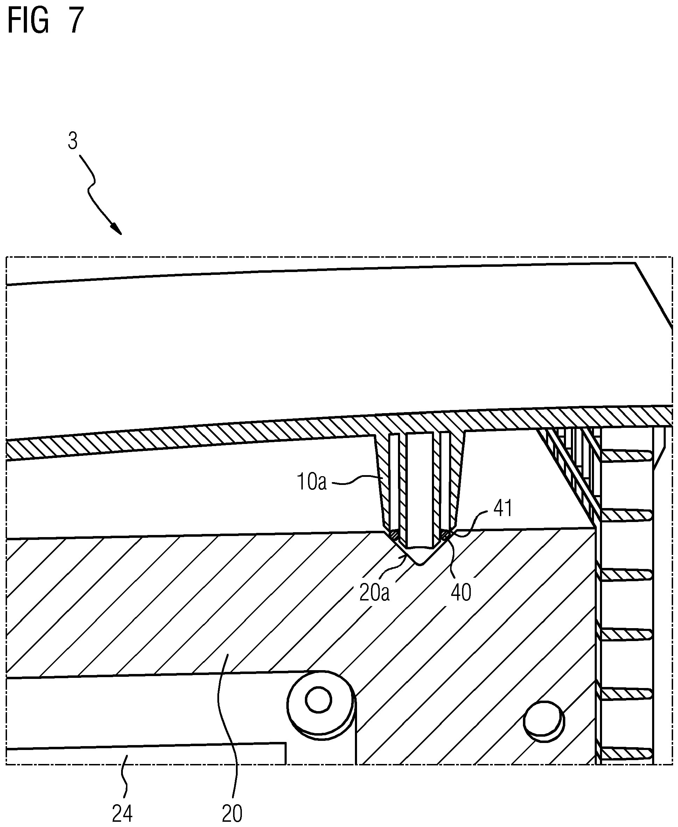

Die Anordnung des O-Ringes wird mit FIG 7, welche eine Schnittdarstellung zeigt, dargestellt. Der Kunststoffdom ist in FIG 7 als das erste Halteelement 10a dargestellt. Der Kunststoffdom weist eine umlaufende Nut 41 auf, in derer ein elastisches Formelement 40, nämlich der O-Ring, eingebracht ist. Andeutungsweise ist auf dem Hauptkühlkörper 20 die Auflagefläche 24 für den Mikroprozessor 30 zu sehen.

Nach einer Montage der Fronthaube 3 auf das Grundgehäuse 2 findet sich dieser Kunststoffdom mit O-Ring in der kegelförmigen Aussparung im Hauptkühlkörper 20 wieder, wobei eine Anlage des O-Ringes am Hauptkühlkörper 20 in allen drei Raumachsen x,y,z immer sichergestellt ist. Auf diese Weise wird ohne großen zusätzlichen Befestigungsaufwand sichergestellt, dass in allen Richtungen, nämlich den drei Raumachsen x,y,z, die Entstehung großer Kräfte vermieden wird und das Automatisierungsgerät 1 somit mechanisch entlastet wird, welches dadurch sehr robust wird. Als Vorteile sind zu nennen: Eine effektive Dämpfung von Schwingungskräften in allen drei Raumrichtungen, eine Verwendung eines einfachen, kostengünstigen Normteiles, nämlich der O-Ring, eine höhere mögliche Rüttelbelastung, welches das Gerät qualitativ hochwertiger macht, eine einfachere Montage einer zusätzlichen Befestigung für einen Hauptkühlkörper. Es können zusätzlich größere, leistungsfähigere Kühlkörper bei annähernd gleichem Aufwand eingesetzt werden.

## Patentansprüche

1. Automatisierungsgerät (1) ausgestaltet für den Einsatz in einem Automatisierungsumfeld zur Automatisierung eines industriellen Prozesses, aufweisend
- ein Grundgehäuse (2),
- eine Fronthaube (3),
- einen Hauptkühlkörper (20) zum Abführen von Wärme eines Mikroprozessors (30),
wobei die Fronthaube (3) auf das Grundgehäuse (2) aufsteckbar ist und zu einem geschlossenem Gehäuse zusammenfügbar ist, welches den Hauptkühlkörper (20) umgibt,
**dadurch gekennzeichnet, dass** der Hauptkühlkörper (20) ist an einer Unterseite (4) des Grundgehäuses (2) mittels eines Festlagers (11,12,13,14) mit dem Grundgehäuse (2) starr verbunden, die Fronthaube (3) weist auf einer Innenseite (5) ein hervorstehendes Halteelement (10a,10b) auf, auf einer Oberseite (22) des Hauptkühlkörpers (20) ist eine Ausnehmung (20a,20b) angeordnet in die das Halteelement (10a,10b) bei geschlossenem Gehäuse eindringt, wobei zwischen dem hervorstehenden Halteelement (10a,10b) und der Ausnehmung (20a,20b) ein elastisches Formelement (40) angeordnet ist, wobei das elastische Formelement (40) ausgestaltet ist Schwingungskräfte des Hauptkühlkörpers (20) in drei Raumachsen (x,y,z) abzufangen.

2. Automatisierungsgerät (1) nach Anspruch 1, wobei das Grundgehäuse (2) an seiner äußeren Unterseite (4) so ausgestaltet ist, dass es auf einer Profilschiene befestigbar ist und die Fronthaube (3) mit ihrem Halteelement (10a,10b) so ausgestaltet ist, dass die Schwingungskräfte des Hauptkühlkörpers (20) auf die Fronthaube (3) übertragen werden und die Fronthaube (3) die Schwingungskräfte des Hauptkühlkörpers (20) auf das Grundgehäuse (2) überträgt und das Grundgehäuse (2) die Schwingungskräfte des Hauptkühlkörpers (20) auf die Profilschiene überträgt.

3. Automatisierungsgerät (1) nach Anspruch 1, wobei das Halteelement (10a,10b) als ein Befestigungsdom mit einer umlaufenden Nut (41) und das elastische Formelement (40) als ein O-Ring ausgestaltet ist, welcher in der Nut (41) liegt.

4. Automatisierungsgerät (1) nach einem der Ansprüche 1 bis 3, wobei die Ausnehmung (20a,20b) kegelförmig ausgestaltet ist.

5. Automatisierungsgerät (1) nach einem der Ansprüche 1 bis 4, weiterhin aufweisend
- eine erste Leiterplatte (31),
- eine zweite Leiterplatte (32) und
- einen Nebenkühlkörper (21),
wobei die erste Leiterplatte (31) zwischen der Unterseite (23) des Hauptkühlkörpers (20) und der Unterseite (4) des Grundgehäuses (4) angeordnet ist, wobei die erste Leiterplatte (31) einen Durchbruch (51,52,53,54) für das Festlager (11,12,13,14) zur Verbindung des Grundgehäuses (2) mit dem Hauptkühlkörper (20) aufweist, die zweite Leiterplatte (32) ist dabei senkrecht auf der ersten Leiterplatte (31) angeordnet und trägt den Mikroprozessor (30) auf der einen Seite der zweiten Leiterplatte (32) und den Nebenkühlkörper (21) auf der anderen Seite der zweiten Leiterplatte (32), dabei liegt eine Seitenfläche des Hauptkühlkörpers (20) auf dem Mikroprozessor (30) auf, sodass der Nebenkühlkörper (21) und der Hauptkühlkörper (20) ein den Mikroprozessor (30) umgebendes Kühlpaket bilden.

6. Automatisierungsgerät (1) nach einem der Ansprüche 1 bis 5, wobei die Ausnehmungen (20a,20b) im Hauptkühlkörper (20) im Bereich der Kante des Hauptkühlkörpers (20), welche zum Nebenkühlkörper (21) gerichtet ist, angeordnet sind.

## Claims

1. Automation device (1) embodied for use in an automation environment for the purpose of automating an industrial process, having
- a basic housing (2),
- a front hood (3),
- a primary heatsink (20) for dissipating heat from a microprocessor (30),
wherein the front hood (3) can be slotted onto the basic housing (2) and assembled to form a closed housing which encloses the primary heatsink (20),
**characterised in that**
the primary heatsink (20) is rigidly connected to the basic housing (2) on a bottom side (4) of the basic housing (2) by means of a locating bearing (11,12,13,14), the front hood (3) has a projecting retaining element (10a,10b) on an inner side (5), there is arranged on a top side (22) of the primary heatsink (20) a recess (20a,20b) into which the retaining element (10a,10b) engages when the housing is closed, wherein an elastic shaped element (40) is arranged between the projecting retaining element (10a,10b) and the recess (20a,20b), wherein the elastic shaped element (40) is embodied to absorb oscillating forces of the primary heatsink (20) in three spatial axes (x,y,z).

2. Automation device (1) according to claim 1, wherein the basic housing (2) is embodied on its external bottom side (4) in such a way that it can be fixedly mounted on a profile rail and the front hood (3) with its retaining element (10a,10b) is embodied in such a way that the oscillating forces of the primary heatsink (20) are transmitted onto the front hood (3) and the front hood (3) transmits the oscillating forces of the primary heatsink (20) onto the basic housing (2) and the basic housing (2) transmits the oscillating forces of the primary heatsink (20) onto the profile rail.

3. Automation device (1) according to claim 1, wherein the retaining element (10a,10b) is embodied as a fastening dome having a circumferential groove (41) and the elastic shaped element (40) is embodied as an O-ring which lies in the groove (41).

4. Automation device (1) according to one of claims 1 to 3, wherein the recess (20a,20b) is embodied as cone-shaped.

5. Automation device (1) according to one of claims 1 to 4, additionally having
- a first printed circuit board (31),
- a second printed circuit board (32) and
- a secondary heatsink (21),
wherein the first printed circuit board (31) is arranged between the bottom side (23) of the primary heatsink (20) and the bottom side (4) of the basic housing (4), wherein the first printed circuit board (31) has an aperture (51,52,53,54) for the locating bearing (11,12,13,14) for the purpose of connecting the basic housing (2) to the primary heatsink (20), the second printed circuit board (32) is in this case arranged vertically on the first printed circuit board (31) and carries the microprocessor (30) on one side of the second printed circuit board (32) and the secondary heatsink (21) on the other side of the second printed circuit board (32), with a lateral surface of the primary heatsink (20) bearing against the microprocessor (30) such that the secondary heatsink (21) and the primary heatsink (20) form a cooling pack enclosing the microprocessor (30).

6. Automation device (1) according to one of claims 1 to 5, wherein the recesses (20a,20b) in the primary heatsink (20) are arranged in the region of the edge of the primary heatsink (20) which is directed toward the secondary heatsink (21).

## Revendications

1. Appareil (1) d'automatisation conformé pour l'utilisation dans un périmètre d'automatisation pour l'automatisation d'un processus industriel, comportant
- un boîtier (2) de base,
- une coiffe (3) avant,
- un refroidisseur (20) principal pour évacuer la chaleur d'un microprocesseur (30),
dans lequel la coiffe (3) avant peut être enfilée sur le boîtier (2) de base et peut être réunie en un boîtier fermé, qui entoure le refroidisseur (20) principal,
**caractérisé en ce que**
le refroidisseur (20) principal est, à un côté (4) inférieur du boîtier (2) de base, relié fixement au boîtier (2) de base, au moyen d'un palier (11, 12, 13, 14) fixe, la coiffe (3) avant a, d'un côté (5) intérieur, un élément (10a, 10b) de maintien en saillie, sur un côté (22) supérieur du refroidisseur (20) principal est prévu un évidement (20a, 20b), dans lequel l'élément (10a, 10b) de maintien pénètre lorsque le boîtier est fermé, dans lequel, entre l'élément (10a, 10b) de maintien en saillie et l'évidement (20a, 20b), est disposé un élément (40) élastique de forme, l'élément (40) élastique de forme étant conformé pour absorber des forces de vibration du refroidisseur (20) principal, dans trois dimensions (x, y, z) de l'espace.

2. Appareil (1) d'automatisation suivant la revendication 1, dans lequel le boîtier (2) de base est conformé, du côté (4) inférieur extérieur, de manière à pouvoir être fixé sur un rail profilé et la coiffe (3) avant est conformée avec son élément (10a, 10b) de maintien, de manière à transmettre les forces de vibration du refroidisseur (20) principal à la coiffe (3) avant et de manière à ce que la coiffe (3) avant transmette les forces de vibration du refroidisseur (20) principal au boîtier (2) de base et de manière à ce que le boîtier (2) de base transfère les forces de vibration du refroidisseur (20) principal aux rails profilés.

3. Appareil (1) d'automatisation suivant la revendication 1, dans lequel l'élément (10a, 10b) de maintien est sous la forme d'un dôme de fixation ayant une rainure (41) faisant le tour et l'élément (40) élastique de forme est conformé sous la forme d'un joint torique, qui se trouve dans la rainure (41).

4. Appareil (1) d'automatisation suivant l'une des revendications 1 à 3, dans lequel l'évidement (20a, 20b) est en forme de sphère.

5. Appareil (1) d'automatisation suivant l'une des revendications 1 à 4, comportant en outre
- une première plaquette (31) à circuit imprimé,
- une deuxième plaquette (32) à circuit imprimé et
- un refroidisseur (21) auxiliaire,
dans lequel la première plaquette (31) à circuit imprimé est disposée entre le côté (23) inférieur du refroidisseur (20) principal et le côté (4) inférieur du boîtier (4) de base, la première plaquette (31) à circuit imprimé ayant une traversée (51, 52, 53, 54) pour le palier (11, 12, 13, 14) fixe de liaison du boîtier (2) de base au refroidisseur (20) principal, la deuxième plaquette (32) à circuit imprimé est disposée perpendiculairement à la première plaquette (31) à circuit imprimé et porte le microprocesseur (30) d'un côté de la deuxième plaquette (32) à circuit imprimé et le refroidisseur (21) auxiliaire de l'autre côté de la deuxième plaquette (32) à circuit imprimé, une surface latérale du refroidisseur (20) principal s'appliquant ainsi au microprocesseur (30), de sorte que le refroidisseur (21) auxiliaire et le refroidisseur (20) principal forment un paquet de refroidissement entourant le microprocesseur (30).

6. Appareil (1) d'automatisation suivant l'une des revendications 1 à 5, dans lequel les évidements (20a, 20b), dans le refroidisseur (20) principal, sont disposés dans la région du bord du refroidisseur (20) principal, qui est dirigé vers le refroidisseur (20) secondaire.
